# EUROPEAN PATENT APPLICATION

(11) **EP 4 752 257 A1**
(43) Date of publication of application: **03.06.2026**
(21) Application number: 25219042.6
(22) Date of filing: 27.11.2025
(51) Int. Cl.: C23C 16/455

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 29.11.2024 JP 2024208295
(71) Applicant: Kokusai Electric Corporation, Tokyo 101-0045 (JP)
(72) Inventor: ARITA, Haruki, Toyama-shi, Toyama 939-2393 (JP); SUYAMA, Nagisa, Toyama-shi, Toyama 939-2393 (JP); TANAKA, Shota, Toyama-shi, Toyama 939-2393 (JP)
(74) Representative: Bardehle Pagenberg Partnerschaft mbB Patentanwälte Rechtsanwälte

(57) **Abstract**

A technique includes a supply process including: (a0) supplying a process gas into a process chamber (201) in which a substrate (200) including a recess on a surface of the substrate (200) is placed; (a1) increasing an internal pressure of the process chamber (201) at least partially simultaneously with (a0); (a2) decreasing the internal pressure of the process chamber (201); and (b) supplying a dilution gas into the process chamber (201) or increasing a flow rate of the dilution gas supplied into the process chamber (201), the supply process being performed so that the internal pressure of the process chamber (201) reaches one or more local maximum values; and an exhaust process of exhausting an interior of the process chamber (201) during at least a portion of the supply process, wherein, in the supply process, (b) is started before (a2) ends for a first time.

## Description

### CROSS-REFERENCE TO RELATED APPLICATION

This application is based upon and claims the benefit of priority from Japanese Patent Application No. 2024-208295, filed on November 29, 2024, the entire contents of which are incorporated herein by reference.

### TECHNICAL FIELD

The present disclosure relates to a method of processing a substrate, a method of manufacturing a semiconductor device, a substrate processing apparatus, and a program.

### BACKGROUND

In the related art, as a step in a process of manufacturing a semiconductor device or processing a substrate, when supplying a process gas into a process chamber in which a substrate is placed, an internal pressure of the process chamber may be increased and then decreased.

### SUMMARY

Some embodiments of the present disclosure provide a technique capable of processing an entire substrate uniformly.

According to embodiments of the present disclosure, there is provided a technique that includes: a supply process including: (a0) supplying a process gas into a process chamber in which a substrate including a recess on a surface of the substrate is placed; (a1) increasing an internal pressure of the process chamber at least partially simultaneously with (a0); (a2) decreasing the internal pressure of the process chamber; and (b) supplying a dilution gas into the process chamber or increasing a flow rate of the dilution gas supplied into the process chamber, the supply process being performed so that the internal pressure of the process chamber reaches one or more local maximum values; and an exhaust process of exhausting an interior of the process chamber during at least a portion of the supply process, wherein, in the supply process, (b) is started before (a2) ends for a first time.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a processing apparatus suitably used in embodiments of the present disclosure, in which a portion of the process furnace is shown in a vertical cross section.
FIG. 2 is a schematic configuration diagram of a controller of the processing apparatus suitably used in the embodiments of the present disclosure, in which a control system of the controller is shown in a block diagram.
FIG. 3 is a diagram showing an example of a gas supply sequence for a film formation process in the embodiments of the present disclosure.
FIG. 4 is a diagram showing a change in a pressure, etc. within a process chamber in a supply process in the embodiments of the present disclosure.
FIG. 5 is a diagram showing a change in a pressure, etc. within the process chamber in a supply process in a modification of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of the Present Disclosure>

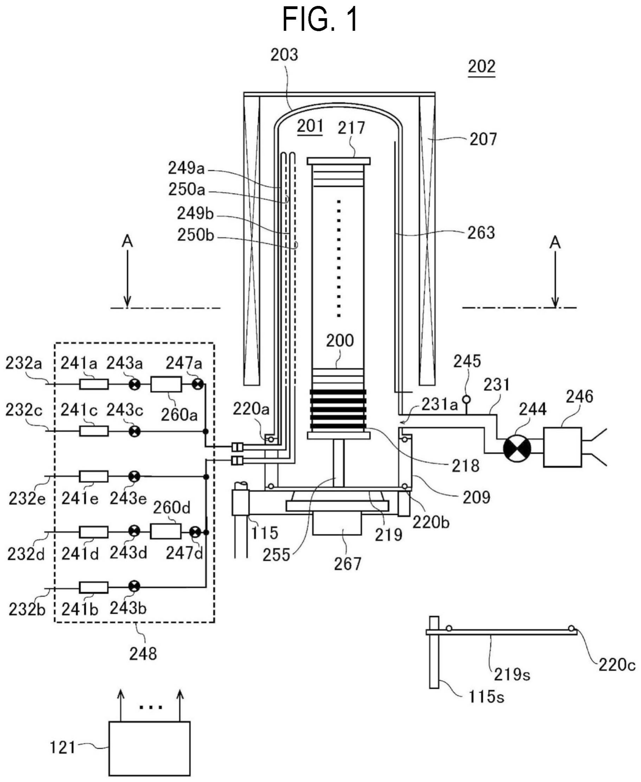

Embodiments of the present disclosure are described mainly with reference to FIGS. 1 to 5. The drawings used in the following description are schematic, and dimensional relationships, proportions, and the like of various elements shown in the drawings may not match the actual ones. Further, the dimensional relationships, proportions, and the like of various elements among multiple figures may not match one another.

### (1) Configuration of Processing Apparatus

As shown in FIG. 1, a process furnace 202 of a processing apparatus includes a heater 207 as a temperature regulator (a heating part). The heater 207 is formed in a cylindrical shape and is supported by a holding plate so as to be vertically installed. The heater 207 functions as an activator (an exciter) that thermally activates (excites) a gas.

A reaction tube 203 is disposed inside the heater 207 to be concentric with the heater 207. The reaction tube 203 is made of, for example, a heat resistant material such as quartz (SiO₂) or silicon carbide (SiC), and is formed in a cylindrical shape with its upper end closed and its lower end opened. A manifold 209 is disposed to be concentric with the reaction tube 203 below the reaction tube 203. An upper end portion of the manifold 209 engages with a lower end portion of the reaction tube 203 so as to support the reaction tube 203. An O-ring 220a serving as a seal is provided between the manifold 209 and the reaction tube 203. A process container (reaction container) mainly includes the reaction tube 203 and the manifold 209. A region in which wafers 200 as substrates are placed, that is, a process chamber 201, is formed in a hollow cylindrical portion of the process container. The process chamber 201 is configured to be capable of accommodating a plurality of wafers 200 as substrates, with the plurality of wafers 200 stacked and disposed in a direction perpendicular to the surfaces of the wafers 200. Processing on the wafers 200 is performed in the process chamber 201.

Nozzles 249a and 249b as first and second suppliers are provided in the process chamber 201 so as to penetrate through a sidewall of the manifold 209. The nozzles 249a and 249b are also referred to as first and second nozzles, respectively. The nozzles 249a and 249b are made of, for example, a heat resistant material such as quartz or SiC. The nozzles 249a to 249b are provided adjacent to each other.

Gas supply pipes 232a and 232b serving as gas supply paths are connected to the nozzles 249a and 249b, respectively. The gas supply pipe 232a is provided with a gas supply source (not shown), a mass flow controller (MFC) 241a serving as a flow rate controller (flow rate control part), a valve 243a serving as an opening/closing valve, a first reservoir 260a configured to be capable of temporarily storing a gas, and a valve 247a serving as a first valve, sequentially from an upstream side of a gas flow. A gas supply pipe 232c is connected to the gas supply pipe 232a at a downstream side of the valve 247a. The gas supply pipe 232c serving as a gas supply flow path is provided with, a gas supply source (not shown), a MFC 241c, and a valve 243c sequentially from an upstream side of a gas flow.

Conductance between the first reservoir 260a and the process chamber 201 is desirably configured to be, for example, 1.5 × 10⁻³ m³/s or greater. Further, considering a ratio between a volume of the process chamber 201 and a volume of the first reservoir 260a, if the volume of the process chamber 201 is 100 L (liters), the volume of the first reservoir 260a is desirably, for example, 100 to 300cc, and is desirably, for example, 1/1,000 to 3/1,000 times the volume of the process chamber 201. The same applies to a second reservoir 260d, which is described below. In the present disclosure, the notation of a numerical range such as "100 to 300cc" means that the lower limit value and the upper limit value are included in the range. Therefore, for example, "100 to 300cc" means "100 or more and 300 or less." The same applies to other numerical ranges.

The gas supply pipe 232b is provided with a gas supply source (not shown), a MFC 241b, and a valve 243b sequentially from an upstream side of a gas flow. Gas supply pipes 232d and 232e as gas supply flow paths are respectively connected to the gas supply pipe 232b at a downstream side of the valve 243b. The gas supply pipe 232d is provided with a gas supply source (not shown), a MFC 241d, a valve 243d, the second reservoir 260d configured to be capable of temporarily storing a gas, and a valve 247d serving as a second valve, sequentially from an upstream side of a gas flow. The gas supply pipe 232e is provided with a gas supply source (not shown), a MFC 241e, and a valve 243e sequentially from an upstream side of a gas flow.

The nozzles 249a and 249b are each installed in a space between an inner wall of reaction tube 203 and the wafers 200 so as to extend upward from a lower portion of the inner wall of the reaction tube 203 to an upper portion of the reaction tube 203, that is, along an arrangement direction of the wafers 200. Gas supply holes 250a and 250b for supplying (discharging) a gas are formed on side surfaces of the nozzles 249a and 249b, respectively. Each of the gas supply holes 250a and 250b is opened so as to oppose (face) an exhaust port 231a, which is described later, in a plane view, thus enabling a gas to be supplied. A plurality of gas supply holes 250a and 250b are formed from a lower portion of the reaction tube 203 to an upper portion of the reaction tube 203.

A precursor gas serving as a process gas is supplied from the gas supply pipe 232a into the process chamber 201 via the MFC 241a, the valve 243a, the first reservoir 260a, the valve 247a, and the nozzle 249a.

A reaction gas serving as a process gas is supplied from the gas supply pipe 232b into the process chamber 201 via the MFC 241b, the valve 243b, and the nozzle 249b.

An inert gas is supplied from the gas supply pipes 232c and 232e into the process chamber 201 via the MFCs 241c and 241e, the valves 243c and 243e, the gas supply pipes 232a and 232b, and the nozzles 249a and 249b, respectively. The inert gas acts as a purge gas, a carrier gas, or the like.

A dilution gas is supplied from the gas supply pipe 232d into the process chamber 201 via the MFC 241d, the valve 243d, the second reservoir 260d, the valve 247d, and the nozzle 249b. The dilution gas acts as a gas that reduces a molar fraction of a process gas (precursor gas) or the like in the process chamber 201.

A precursor gas supply system mainly includes the gas supply pipe 232a, the MFC 241a, the valve 243a, the first reservoir 260a, and the valve 247a. A reaction gas supply system mainly includes the gas supply pipe 232b, the MFC 241b, and the valve 243b. An inert gas supply system mainly includes the gas supply pipes 232c and 232e, the MFCs 241c and 241e, and the valves 243c and 243e. A dilution gas supply system mainly includes the gas supply pipe 232d, the MFC 241d, the valve 243d, the second reservoir 260d, and the valve 247d. The precursor gas supply system, the reaction gas supply system, and the dilution gas supply system are collectively referred to simply as a supply system. Gas supply sources may also be included in the supply system.

Any of or the entire above-described various supply systems may be configured as an integrated-type supply system 248 in which the valves 243a to 243e, 247a, and 247d, the MFCs 241a to 241e, the first reservoir 260a, the second reservoir 260d, and so on are integrated. The integrated-type supply system 248 is connected to each of the gas supply pipes 232a to 232e, and is configured such that operations of supplying various substances (various gases) into the gas supply pipes 232a to 232e, the first reservoir 260a, and the second reservoir 260d, i.e., opening/closing operations of the valves 243a to243e, 247a, and 247d and flow rate regulating operations by the MFCs 241a to241e, and so on, are controlled by a controller 121, which is described later.

The exhaust port 231a for exhausting an internal atmosphere of the process chamber 201 is provided below the sidewall of the reaction tube 203. In a plane view, the exhaust port 231a is provided at a position opposing (facing) the nozzles 249a and 249b (the gas supply holes 250a and 250b) with the wafers 200 interposed therebetween. An exhaust pipe 231 is connected to the exhaust port 231a. A vacuum pump 246, which serves as a vacuum exhauster, is connected to the exhaust pipe 231 via a pressure sensor 245, which serves as a pressure detector (pressure detection part) for detecting an internal pressure of the process chamber 201, and an APC (Auto Pressure Controller) valve 244, which serves as a pressure regulator (pressure regulating part). The APC valve 244 is configured to perform or stop vacuum-exhaust in the process chamber 201 by opening/closing the valve while the vacuum pump 246 is actuated, and is also configured to regulate the internal pressure of the process chamber 201 by adjusting an opening degree of the valve based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219, which serves as a furnace opening lid configured to hermetically seal an opening at a lower end of the manifold 209, is provided below the manifold 209. An O-ring 220b, which is a seal making contact with the lower end of the manifold 209, is provided on an upper surface of the seal cap 219. A rotator 267 configured to rotate a boat 217, which is described later, is installed below the seal cap 219. A rotary shaft 255 of the rotator 267 is connected to the boat 217 through the seal cap 219. The rotator 267 is configured to rotate the wafers 200 around a center of a surface of the wafer 200 as an axis by rotating the boat 217. The seal cap 219 is configured to be vertically raised or lowered by a boat elevator 115 which is a lift installed outside the reaction tube 203. The boat elevator 115 is configured as a transferrer (transfer mechanism) which loads/unloads (transfers) the wafers 200 into/out of the process chamber 201 by raising or lowering the seal cap 219.

A shutter 219s, which serves as a furnace opening lid configured to hermetically seal the opening at the lower end of the manifold 209 in a state where the seal cap 219 is lowered and the boat 217 is unloaded from the process chamber 201, is provided below the manifold 209. An O-ring 220c, which is a seal making contact with the lower end of the manifold 209, is provided on an upper surface of the shutter 219s. An opening/closing operation of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. At a lower portion of the boat 217, heat insulating plates 218 made of, for example, a heat resistant material such as quartz or SiC are supported in multiple stages.

A temperature sensor 263 serving as a temperature detector is installed in the reaction tube 203. Based on temperature information detected by the temperature sensor 263, a state of supplying electric power to the heater 207 is regulated such that a temperature inside the process chamber 201 achieves a desired temperature distribution. The temperature sensor 263 is provided along the inner wall of the reaction tube 203.

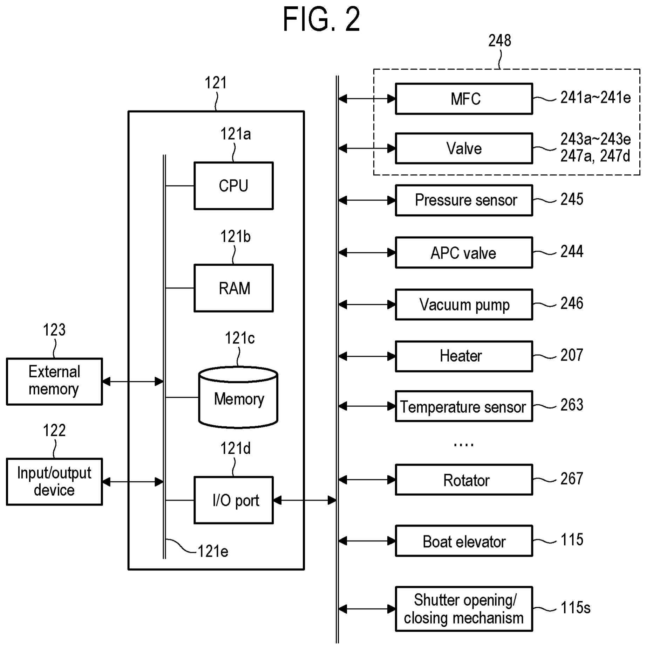

As shown in FIG. 2, a controller 121, which is a control part (control means), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 formed of, e.g., a touch panel or the like, is connected to the controller 121. Further, an external memory 123 may be connected to the controller 121. Also, the processing apparatus may be configured to include one controller, or may be configured to include a plurality of controllers. That is, control for performing a processing sequence to be described later may be performed by using one controller, or may be performed by using a plurality of controllers. Further, the plurality of controllers may be configured as a control system in which the plurality of controllers are connected to each other via a wired or wireless communication network, and the entire control system may perform control for performing the processing sequence to be described later. When the term "controller" is used in the present disclosure, it may refer to a case of including a single controller, as well as a case of including a plurality of controllers or a case of including a control system configured by a plurality of controllers.

The memory 121c is configured by, for example, a flash memory, a hard disk drive (HDD), a solid state drive (SSD), or the like. A control program for controlling operations of a processing apparatus, a process recipe in which sequences and conditions of substrate processing to be described later are written, etc. are readably recorded and stored in the memory 121c. The process recipe is a combination that causes the controller 121 to execute each sequence in the substrate processing (film formation process and the like), which is described later, in the processing apparatus to obtain an expected result, and functions as a program. Hereinafter, the process recipe, the control program, or the like may be generally and simply referred to as a "program (program product)." Further, the process recipe may be simply referred to as a "recipe." When the term "program" is used herein, it may indicate a case of solely including the recipe, a case of solely including the control program, or a case of including both the recipe and the control program. The RAM 121b is configured as a memory area (work area) in which programs, data, or the like read by the CPU 121a are temporarily stored.

The I/O port 121d is connected to the MFCs 241a to 241e, the valves 243a to 243e, 247a, and 247d, the pressure sensor 245, the APC valve 244, the vacuum pump 246, the temperature sensor 263, the heater 207, the rotator 267, the boat elevator 115, the shutter opening/closing mechanism 115s, and so on.

The CPU 121a is configured to read and execute the control program from the memory 121c. The CPU 121a is also configured to read the recipe from the memory 121c according to an input of an operation command from the input/output device 122. The CPU 121a is configured to be capable of, according to contents of the read recipe, controlling flow rate regulating operations of various kinds of substances (gases) by the MFCs 241a to 241e, opening/closing operations of the valves 243a to 243e, 247a, and 247d, a pressure regulating operation performed by the APC valve 244 based on an opening/closing operation of the APC valve 244 and the pressure sensor 245, start and shutdown of the vacuum pump 246, a temperature regulating operation performed by the heater 207 based on the temperature sensor 263, an operation of rotating the boat 217 with the rotator 267 and adjusting a rotation speed of the boat 217, an operation of raising or lowering the boat 217 by the boat elevator 115, an opening/closing operation of the shutter 219s by the shutter opening/closing mechanism 115s, and so on.

The controller 121 may be configured by installing, on the computer, the aforementioned program recorded and stored in the external memory 123. Examples of the external memory 123 may include a magnetic disk such as a HDD, an optical disc such as a CD, a semiconductor memory such as a USB memory or a SSD, and the like. The memory 121c or the external memory 123 is configured as a non-transitory computer-readable recording medium. Hereinafter, the memory 121c and the external memory 123 may be generally and simply referred to as a "recording medium." When the term "recording medium" is used herein, it may indicate a case of solely including the memory 121c, a case of solely including the external memory 123, or a case of including both the memory 121c and the external memory 123. Further, the program may be provided to the computer by using communication means such as the Internet or a dedicated line, instead of using the external memory 123.

### (2) Processing Process

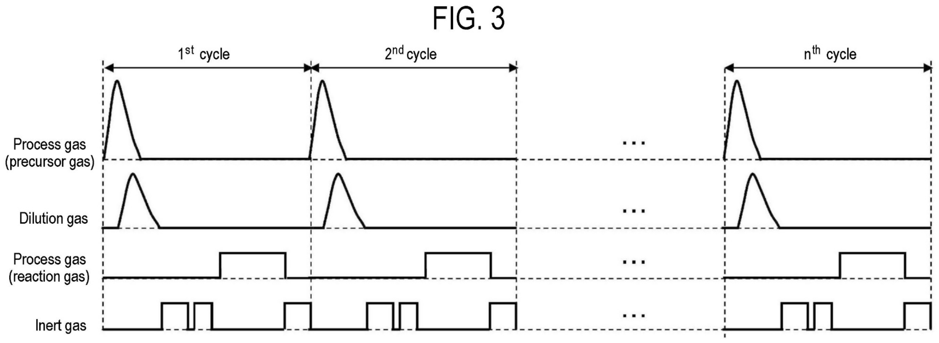

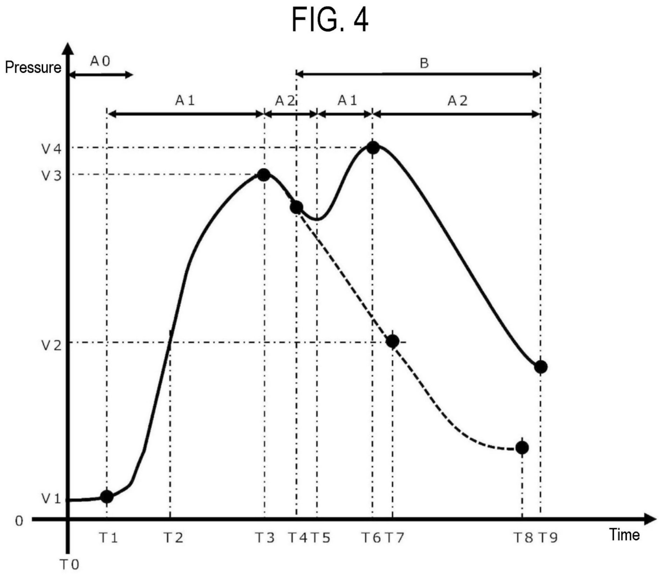

As one of processes (methods) of manufacturing a semiconductor device by using the above-described processing apparatus, an example of a method of processing a substrate, that is, a film formation sequence for forming a film on a wafer 200 as a substrate, is described mainly with reference to FIGS. 3 and 4. In the present embodiments, an example in which a silicon substrate (silicon wafer) with recesses such as trenches and holes formed in its surface, as the wafer 200, is described. In the following description, operations of each part constituting the processing apparatus is controlled by the controller 121.

A processing sequence in the present embodiments includes:
a supply process (supply step) including:
   (a0) step A0 of supplying a precursor gas as a process gas into a process chamber 201 in which a wafer 200 including a recess on a surface of the wafer 200 is placed;
   (a1) step A1 of increasing an internal pressure of the process chamber 201 at least partially simultaneously with step A0;
   (a2) step A2 of decreasing the internal pressure of the process chamber 201; and
   (b) step B of supplying a dilution gas into the process chamber 201 or increasing
a flow rate of the dilution gas supplied into the process chamber 201,
   the supply process (supply step) being performed so that the internal pressure of the process chamber 201 reaches one or more local maximum values; and
an exhaust process (exhaust step) of exhausting an interior of the process chamber 201 during at least a portion of the supply step,
wherein, in the supply step, step B is started before step A2 ends for a first time.

In the following, the supply step including steps A0, A1, A2, and B is also be referred to as a first processing step.

In the following example, as shown in FIG. 4, a case is described in which in the supply step (the first processing step), step B is started after the internal pressure of the process chamber 201 reaches a first local maximum value.

In the following example, a case is described in which a film formation process (film formation step) of forming a film containing a predetermined element on the wafer 200 is performed. Specifically, a case is described in which a film formation step of forming a film on the wafer 200 by performing a cycle a predetermined number of times (n times, where n is an integer of 1 or 2 or more), the cycle non-simultaneously performing the first processing step and a second processing step of supplying a reaction gas as a process gas, is performed.

When the term "wafer" is used in the present disclosure, it may refer to "a wafer itself" or "a stacked body including a wafer and a predetermined layer or film formed on a surface of the wafer." When the phrase "a surface of a wafer" is used in the present disclosure, it may refer to "a surface of a wafer itself" or "a surface of a predetermined layer formed on a wafer." When the expression "a predetermined layer is formed on a surface of a wafer" is used in the present disclosure, it may mean that "a predetermined layer is formed directly on a surface of a wafer itself" or that "a predetermined layer is formed on a layer and the like formed on a wafer." When the term "substrate" is used in the present disclosure, it may be synonymous with the term "wafer."

The term "substance" used in the present disclosure includes at least one selected from the group of a gaseous substance and a liquid state substance. The liquid state substance includes a mist state substance.

The term "layer" used in the present disclosure includes at least one selected from the group of a continuous layer and a discontinuous layer. For example, a first layer and a second layer, which are described later, may include a continuous layer, a discontinuous layer, or both of them.

In the present disclosure, when describing that the precursor gas or reaction gas is adsorbed on or reacts with the surface of the wafer 200, it is to be understood that the description includes cases where the gases are adsorbed on or react with the wafer surface in an undecomposed state, as well as cases where intermediates generated by decomposition of the gases or by dissociation of their ligands are adsorbed on or react with the surface of the wafer 200.

### (Wafer Charging and Boat Loading)

When the boat 217 is charged with a plurality of wafers 200, the opening at the lower end of the manifold 209 is opened. Then, as shown in FIG. 1, the boat 217 supporting the plurality of wafers 200 is lifted up by the boat elevator 115 and is loaded into the process chamber 201. In this way, the wafers 200 are prepared inside the process chamber 201.

### (Pressure Regulation and Temperature Regulation)

After the boat loading is completed, the interior of the process chamber 201 is vacuum-exhausted (depressurization-exhausted) by the vacuum pump 246 to reach a desired pressure (degree of vacuum). At this time, the internal pressure of the process chamber 201 is measured by the pressure sensor 245, and the APC valve 244 is feedback-controlled based on the measured pressure information. Further, the wafers 200 in the process chamber 201 are heated by the heater 207 so as to reach a desired processing temperature. At this time, the state of supplying electric power to the heater 207 is feedback-controlled based on the temperature information detected by the temperature sensor 263 so that the interior of the process chamber 201 achieves a desired temperature distribution. Further, the rotation of the wafers 200 by the rotator 267 is started. The exhaust of the interior of the process chamber 201 and the heating and rotation of the wafers 200 are continuously performed at least until the processing on the wafers 200 is completed.

### (Filling with Precursor Gas and Dilution Gas)

After that, with the valve 247a closed, the valve 243a is opened to allow a precursor gas to flow into the gas supply pipe 232a. A flow rate of the precursor gas is regulated by the MFC 241a, and the precursor gas is supplied into the first reservoir 260a. As a result, the first reservoir 260a is filled with the precursor gas at a pressure increased to a filling pressure. Once the first reservoir 260a is filled with a predetermined amount of precursor gas, the valve 243a is closed to maintain the state in which the first reservoir 260a is filled with the precursor gas. Further, with the valve 247d closed, the valve 243d is opened to allow a dilution gas to flow into the gas supply pipe 232b. A flow rate of the dilution gas is regulated by the MFC 241d, and the dilution gas is supplied into the second reservoir 260d. As a result, the second reservoir 260d is filled with the dilution gas at a pressure increased to a filling pressure. Once the second reservoir 260d is filled with a predetermined amount of dilution gas, the valve 243d is closed to maintain the state in which the second reservoir 260d is filled with the dilution gas. In addition, as long as the filling of the second reservoir 260d with the dilution gas is completed when the dilution gas is supplied, the filling of the dilution gas may be performed after the first processing step begins.

### (Film Formation Process)

After that, a first processing step and a second processing step are performed sequentially.

### [First Processing Step]

First, the precursor gas is supplied to the wafer 200 in the process chamber 201.

Specifically, the valve 247a is opened to allow the high-pressure precursor gas filled in the first reservoir 260a to flow into the depressurized process chamber 201. In the present disclosure, this method of supplying a gas to the wafer 200 using a pressure difference is also referred to as "flash supply." At this time, the valves 243c and 243e may be opened to allow an inert gas to be supplied into the process chamber 201 via the nozzles 249a and 249b. At this time, the valve opening degree of the APC valve 244 is set to a predetermined state as needed.

A change in the internal pressure of the process chamber 201 that occurs when the precursor gas is supplied into the process chamber 201 is described below with reference to FIG. 4. In FIG. 4, the vertical axis represents the internal pressure of the process chamber 201, and the horizontal axis represents time. A solid line shown in FIG. 4 indicates the change in the internal pressure of the process chamber 201 during the first processing step. A broken line shown in FIG. 4 indicates the change in the internal pressure of the process chamber 201 after time T4 when no dilution gas is supplied into the process chamber 201 within a predetermined time after the start of the flash supply of the precursor gas.

The internal pressure of the process chamber 201 in which the flash supply of the precursor gas is started by opening the valve 247a increases sharply between time T1 and time T3 and reaches a local maximum value V3 at time T3. The internal pressure of the process chamber 201 that reached the local maximum value V3 then decreases between time T3 and time T8. As shown in FIG. 4, the internal pressure of the process chamber 201 reaches the local maximum value at time T3.

A period from time T1 to time T3 is a pressure increase period during which the internal pressure of the process chamber 201 (herein, a partial pressure of the precursor gas) increases. The increase of the partial pressure of the precursor gas allows the precursor gas to reach both an opening side of the recess (hereinafter simply referred to as the opening side) and a deep side of the recess (hereinafter simply referred to as the deep side). This makes it possible to improve step coverage. For example, if a pressure V2 at time T2 is set to half of the local maximum value V3, it is possible to make the partial pressure of the precursor gas particularly high during the pressure increase period from time T2 to time T3, thereby further improving the step coverage.

On the other hand, a period from time T3 to time T8 is a pressure decrease period during which the internal pressure of the process chamber 201 (herein, the partial pressure of the precursor gas) decreases. The decrease of the partial pressure of the precursor gas may make it difficult for the precursor gas to reach the deep side. For example, if a pressure V2 at time T7 is set to half of the local maximum value V3, the partial pressure of the precursor gas is high during the pressure decrease period from time T3 to time T7, thereby maintaining high step coverage. In contrast, the partial pressure of the precursor gas is relatively low during the period from time T7 to time T8, which may result in a decrease in step coverage. Further, after a predetermined time is elapsed (e.g., when it reaches time T3) since the start of the flash supply of the precursor gas (time T1), thermal decomposition of the precursor gas remaining in the process chamber 201 is started, generating highly reactive decomposition products. Since the decomposition products are more likely to adsorb on the opening side than to the deep side, the greater the amount of decomposition products present in the process chamber 201, the more likely a thick layer (film) is to form on the opening side, further reducing the step coverage.

Therefore, in the embodiments, after the start of the flash supply of the precursor gas (e.g., time T0), the dilution gas is supplied into the process chamber 201 during the period from time T3 to time T8, preferably during the period from time T3 to time T7.

Specifically, the valve 247d is opened to allow the high-pressure dilution gas stored in the second reservoir 260d to flow into the process chamber 201. At this time, the valves 243c and 243e may be opened to allow an inert gas to be supplied into the process chamber 201 via the nozzles 249a and 249b.

The dilution gas is flash-supplied by opening the valve 247d. After the start of the flash supply of the dilution gas (e.g., time T4), the internal pressure of the process chamber 201 increases between time T5 and time T6 and reaches a local maximum value V4 at time T6. The internal pressure of the process chamber 201 that reached the local maximum value V4 then decreases between time T6 and time T9, and the decrease in the internal pressure of the process chamber 201 ends at time T9. As shown in FIG. 4, the internal pressure of the process chamber 201 reaches the local maximum value at time T6. From the start of the flash supply of dilution gas until the end of the decrease in the internal pressure of the process chamber 201 at time T9, the precursor gas and decomposition products remaining in the process chamber 201 are continuously discharged from the process chamber 201. Herein, a step of discharging the precursor gas and decomposition products from the process chamber 201 is also referred to as an exhaust step. By supplying the dilution gas into the process chamber 201 as described above, it is possible to discharge the precursor gas and decomposition products remaining in the process chamber 201 out of the process chamber 201 in large quantities more quickly and in a shorter period of time than when no dilution gas is supplied into the process chamber 201 (as indicated by the broken line in FIG. 4).

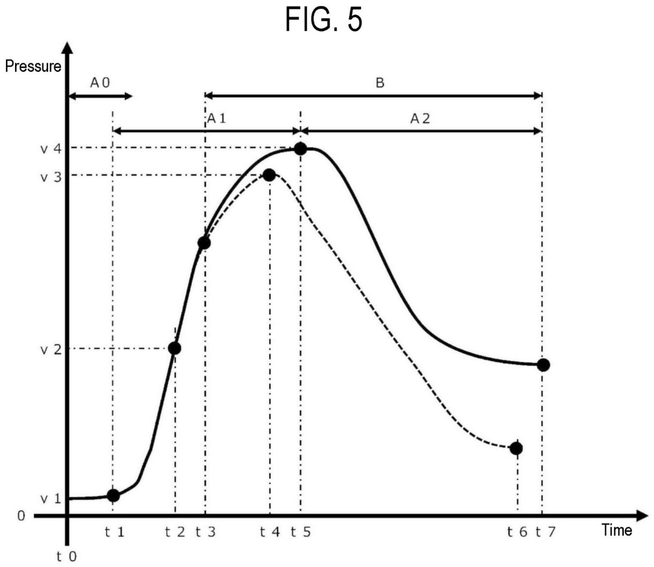

The step of supplying the precursor gas into the process chamber 201 is referred to as step A0. The step of increasing the internal pressure of the process chamber 201, for example, from time T1 to time T3, is referred to as first step A1 (step A1 performed for the first time in the supply step). The step of decreasing the internal pressure of the process chamber 201, for example, from time T3 to time T5, is referred to as first step A2 (step A2 performed for the first time in the supply step). The step of supplying the dilution gas into the process chamber 201 is referred to as step B. The step of increasing the internal pressure of the process chamber 201, for example, from time T5 to time T6, is referred to as second step A1 (step A1 performed for the second time in the supply step). The step of decreasing the internal pressure of the process chamber 201, for example, from time T6 to time T9, is referred to as second step A2 (step A2 performed for the second time in the supply step). The local maximum value at time T3 is referred to as a first local maximum value, and the local maximum value at time T6 is referred to as a second local maximum value. In FIG. 4, periods during which steps A0, A1, A2, and B are performed are represented as A0, A1, A2, and B, respectively. This also applies to FIG. 5. Also, steps A0 and B are initiated by sending commands from the controller 121 to the valves 247a and 247d to open the valves 247a and 247d respectively. In addition, the start of step B refers to a time point at which the dilution gas begins to be supplied into the process chamber 201, in other words, a time point at which the dilution gas reaches the process chamber 201.

By supplying a process gas containing a predetermined element (i.e., the precursor gas containing the predetermined element) to the wafer 200 under a process condition to be described later, it is possible to form a first layer containing the predetermined element on the surface of the wafer 200. The first layer is formed by adsorption of the precursor gas or adsorption of the decomposition products formed by the thermal decomposition of a portion of the precursor gas on an outermost surface of the wafer 200.

After the decrease of the internal pressure of the process chamber 201 ends, the valve 247d is closed to stop the supply of the dilution gas into the process chamber 201. The interior of the process chamber 201 is then depressurized (e.g., vacuum-exhausted) to remove decomposition products, etc. remaining in the process chamber 201 from the process chamber 201. At this time, the valves 243c and 243e are opened to allow a third flow rate of inert gas to be supplied into the process chamber 201 via the nozzles 249a and 249b. This makes it difficult for a gas in the process chamber 201 to penetrate into the nozzles 249a and 249b. The interior of the process chamber 201 is then exhausted while a fourth flow rate of inert gas, which is equal to or greater than the third flow rate, is supplied into the process chamber 201. At this time, the inert gas supplied from the nozzles 249a and 249b acts as a purge gas. This purges a space in which the wafers 200 exist, i.e., the interior of the process chamber 201 (purging). The step of performing vacuum-exhaust and/or purging here is also referred to as an exhaust step. The inert gas supplied in this purging is desirably supplied with a lower supply flow rate and a shorter supply time than the dilution gas supplied in step B. As shown in FIG. 3, this depressurization and purging is preferably performed a plurality of times (e.g., 2 to 20 times) (cycle purging).

When the predetermined element is silicon (Si), it is possible to use a silane-based gas as the precursor gas. For example, a gas containing Si and a halogen, i.e., a halosilane-based gas, may be used as the silane-based gas. The halogen may be at least one selected from the group of chlorine (Cl), fluorine (F), bromine (Br), and iodine (I).

The precursor gas may be a chlorosilane-based gas, such as a tetrachlorosilane (SiCl₄) gas, a monochlorosilane (SiH₃Cl) gas, a dichlorosilane (SiH₂Cl₂) gas, a trichlorosilane (SiHCl₃) gas, or the like, that does not contain Si-Si bonds (i.e., bonds between the predetermined elements) in one molecule. In addition to the chlorosilane-based gas, the process gas may also be a fluorosilane-based gas, such as a tetrafluorosilane (SiF₄) gas, a difluorosilane (SiH₂F₂) gas or the like; a bromosilane-based gas, such as a tetrabromosilane (SiBr₄) gas, a dibromosilane (SiH₂Br₂) gas, or the like; or an iodosilane-based gas, such as a tetraiodosilane (SiI₄) gas, a diiodosilane (SiH₂I₂) gas, or the like, that does not contain Si-Si bonds (i.e., bonds between the predetermined elements) in its molecular structure.

In addition, the precursor gas may be a chlorosilane-based gas, such as a hexachlorodisilane (Si₂Cl₆) gas, an octachlorotrisilane (Si₃Cl₈) gas, a monochlorodisilane (Si₂H₃Cl) gas, a dichlorodisilane (Si₂H₄Cl₂) gas, a trichlorodisilane (Si₂H₃Cl₃) gas, a tetrachlorodisilane (Si₂H₂Cl₄) gas, a monochlorotrisilane (Si₃H₅Cl) gas, a dichlorotrisilane (Si₃H₄C₁₂) gas, or the like, that contains two or more Si atoms (i.e., two or more atoms of the predetermined element) in its molecular structure.

In addition to these, the precursor gas may also be a gas containing Si and an amino group in one molecule, i.e., an aminosilane gas. The amino group is a monovalent functional group formed by removing hydrogen (H) from ammonia, primary amine, or secondary amine, and may be represented as -NH₂, -NHR, or -NR₂. R represents an alkyl group, and two Rs in - NR₂ may be the same or different.

The precursor gas may also be an aminosilane gas, such as a tetrakis(dimethylamino)silane (Si[N(CH₃)₂]₄) gas, a tris(dimethylamino)silane (Si[N(CH₃)₂]₃H) gas, a bis(diethylamino)silane (Si[N(C₂H₅)₂]₂H₂) gas, a bis(tertiarybutylamino)silane (SiH₂[NH(C₄H₉)]₂) gas, a (diisopropylamino)silane (SiH₃[N(C₃H₇)₂]) gas, or the like.

One or more of these gases may be used as the precursor gas.

The inert gas may be a nitrogen (N₂) gas or a rare gas such as an argon (Ar) gas, a helium (He) gas, a neon (Ne) gas, a xenon (Xe) gas, or the like. One or more of these gases may be used as the inert gas. This also applies to the steps to be described below.

The dilution gas may be, for example, the same gas as the inert gas described above. One or more of these gases may be used as the dilution gas.

### [Second Processing Step]

After that, the reaction gas as a process gas is supplied to the wafer 200 in the process chamber 201.

Specifically, the valve 243b is opened to allow the reaction gas to flow into the gas supply pipe 232b. A flow rate of the reaction gas is regulated by the MFC 241b, and the reaction gas is supplied into the process chamber 201 via the nozzle 249b and is exhausted through the exhaust port 231a. In this operation, the reaction gas is supplied to the wafer 200 (reaction gas supplying). At this time, the valves 243c and 243e may be opened to allow an inert gas to be supplied into the process chamber 201 via the nozzles 249a and 249b.

By supplying the reaction gas to the wafer 200 under a process condition to be described later, at least a portion of the first layer formed on the wafer 200 reacts with the reaction gas and is modified. As a result, a second layer, which is a modified layer of the first layer, is formed on the wafer 200.

As the reaction gas, for example, an oxidizing gas may be used. As the oxidizing gas, for example, an oxygen (O)- and H-containing gas may be used. As the O- and H-containing gas, for example, water vapor (H₂O gas), a hydrogen peroxide (H₂O₂) gas, a hydrogen (H₂) gas + oxygen (O₂) gas, a H₂ gas + ozone (O₃) gas, etc. may be used. In addition to the O- and H-containing gas, for example, an O-containing gas may also be used as the oxidizing gas. As the O-containing gas, for example, an O₂ gas, an O₃ gas, a nitrous oxide (N₂O) gas, a nitric oxide (NO) gas, a nitrogen dioxide (NO₂) gas, a carbon monoxide (CO) gas, a carbon dioxide (CO₂) gas, etc. may be used. The O- and H-containing gas is also a type of the O-containing gas. One or more of these gases may be used as the oxidizing gas. Also, in the present disclosure, the description of two gases such as "H₂ gas + O₂ gas" together means a mixture gas of H₂ gas and O₂ gas. When supplying the mixture gas, the two gases may be mixed (pre-mixed) in a supply pipe and then supplied into the process chamber 201, or the two gases may be supplied separately from different supply pipes into the process chamber 201 and then mixed (post-mixed) in the process chamber 201.

After forming the second layer on the surface of the wafer 200, the valve 243b is closed to stop the supply of the reaction gas into the process chamber 201. The process chamber 201 is then vacuum-exhausted to remove decomposition products, etc. remaining in the process chamber 201 from the process chamber 201. At this time, the valves 243c and 243e are opened to allow an inert gas be supplied into the process chamber 201 via the nozzles 249a and 249b. The inert gas supplied from the nozzles 249a and 249b acts as a purge gas, whereby the interior of the process chamber 201 is purged (purging).

### [Performing Predetermined Number of Times]

A film is formed on the surface of the wafer 200 by performing a cycle a predetermined number of times (n times, where n is an integer of 1 or 2 or more), the cycle performing the above-described first and second processing steps non-simultaneously, i.e., asynchronously, in this order. For example, if the predetermined element contained in the precursor gas is Si and the reaction gas is an oxidizing gas, it is possible to form a silicon oxide film (SiO film) on the surface of the wafer 200. The above cycle may be repeated a plurality of times. That is, a thickness of the second layer formed per cycle may be set to be thinner than a desired film thickness, and the above cycle may be repeated a plurality of times until a thickness of a film formed by stacking the second layers reaches the desired film thickness.

Below are examples of the process conditions for supplying the gases in the first and second processing steps.

A process condition for supplying the precursor gas in the first processing step is exemplified as follows:
Processing temperature: 250 to 800 degrees C, specifically 600 to 700 degrees C
Processing pressure: 1 to 2,666 Pa, specifically 1 to 1,333 Pa
Precursor gas supply flow rate: 1 to 500 slm, specifically 10 to 200 slm
Precursor gas supply time: 0.01 to 5 seconds, specifically 0.5 to 5 seconds
Precursor gas partial pressure: 0.00005 to 3,999 Pa, specifically 0.06 to 1,333 Pa
Inert gas supply flow rate (for each gas supply pipe: second flow rate): 0 to 5 slm

Herein, the inert gas supply flow rate (second flow rate) is desirably equal to or less than the first flow rate which is a supply flow rate of the dilution gas to be described below.

In the present disclosure, the processing temperature means a temperature of the wafer 200 or an internal temperature of the process chamber 201, and the processing pressure means the internal pressure of the process chamber 201. Further, the processing time means a time during which a process is continued. Further, the supply flow rate of 0 slm means a case where no substance (gas) is supplied. These apply equally to the following description.

A process condition for supplying the dilution gas in the first processing step is exemplified as follows:
Dilution gas supply flow rate (first flow rate): 10 to 500 slm, specifically 10 to 300 slm
Dilution gas supply time: 0.5 to 10 seconds, specifically 0.5 to 5 seconds
Dilution gas partial pressure: 0.00005 to 2,999 Pa, specifically 0.06 to 1,333 Pa

Other conditions may be the same as the process condition for supplying the precursor gas.

A process condition for depressurizing (or vacuum-exhausting) the interior of the process chamber 201 in the exhaust step is exemplified as follows:
Inert gas supply flow rate (third flow rate): 0 to 5 slm
Inert gas supply time: 0.5 to 10 seconds

A processing temperature may be the same as the process condition for supplying the precursor gas.

A process condition for purging the interior of the process chamber 201 in the exhaust step is exemplified as follows:
Inert gas supply flow rate (fourth flow rate): 10 to 300 slm
Inert gas supply time: 0.5 to 10 seconds

A processing temperature may be the same as the process condition for supplying the precursor gas. Herein, it is desirable that at least one selected from the group of following conditions be met: purging is performed for a shorter time than step B; and the fourth flow rate is lower than the dilution gas supply flow rate (first flow rate) in step B.

A process condition for supplying the reaction gas in the second processing step is exemplified as follows:
Reaction gas supply flow rate: 1 to 10 slm, specifically 1 to 5 slm
Reaction gas supply time: 1 to 120 seconds, specifically 1 to 60 seconds

Other conditions may be the same as the process condition for supplying the precursor gas.

### (After-Purge and Returning to Atmospheric Pressure)

After the formation of the film with the desired thickness on the wafer 200 is completed, an inert gas acting as a purge gas is supplied into the process chamber 201 from each of the nozzles 249a and 249b and is exhausted through the exhaust port 231a. Thus, the interior of the process chamber 201 is purged and a gas, decomposition products, etc. remaining in the process chamber 201 are removed from the process chamber 201. After that, the internal atmosphere of the process chamber 201 is substituted with an inert gas and the internal pressure of the process chamber 201 is returned to the atmospheric pressure.

### (Boat Unloading and Wafer Discharging)

After that, the seal cap 219 is lowered by the boat elevator 115 to open the lower end of the manifold 209. Then, the processed wafers 200 supported by the boat 217 are unloaded from the lower end of the manifold 209 to an outside of the reaction tube 203. After being unloaded to the outside of the reaction tube 203, the processed wafers 200 are taken out from the boat 217.

### (3) Effects of the Present Embodiments

According to the present embodiments, one or more effects set forth below may be achieved.
(a) By performing step A1, which increases the internal pressure of the process chamber 201, at least partially simultaneously with step A0, it is possible to increase the partial pressure of the precursor gas within the process chamber 201. Therefore, it is possible to increase an amount of precursor gas molecules that reach the deep side. This reduces a difference in thickness between films formed on the open side and the deep side, thereby improving the step coverage of the film formed in the recess.
   Further, by starting step B before step A2 ends for the first time, the precursor gas is less likely to stay (remain) in the process chamber 201 for a long time, while reducing a molar fraction of the decomposition products (or a partial pressure of the decomposition products) in the process chamber 201. This makes it possible to suppress local adsorption of the decomposition products on the opening side, thereby improving the step coverage of the film formed in the recess.
(b) By starting step B after the internal pressure of the process chamber 201 reaches the first local maximum value, the partial pressure of the precursor gas is sufficiently increased, making it easier for the precursor gas to reach the deep side, and allowing the precursor gas and decomposition products to be discharged outside the process chamber 201. This further improves the step coverage of the film formed in the recess.
(c) By performing step B such that the internal pressure of the process chamber 201 reaches a local maximum value after step B is started, i.e., by supplying a large flow rate of the dilution gas into the process chamber 201 in step B, the precursor gas and decomposition products are more easily discharged outside the process chamber 201. This further improves the step coverage of the film formed in the recess.
(d) By starting step B during a period in which the internal pressure of the process chamber 201 is equal to or greater than half of the local maximum value V3 of the internal pressure of the process chamber 201 in the supply step, it is possible to discharge the precursor gas outside the process chamber 201 before the thermal decomposition of the precursor gas progresses, while ensuring a period during which the partial pressure of the precursor gas is high. This further improves the step coverage of the film formed in the recess.
(e) By completing step B after the internal pressure of the process chamber 201 stops decreasing, i.e., by continuing step B until the internal pressure of the process chamber 201 stops decreasing, it is easier to discharge the precursor gas and decomposition products remaining in the process chamber 201 from the process chamber 201. This reliably improves the step coverage.
(f) By supplying the precursor gas stored in advance in the first reservoir 260a into the process chamber 201 during at least a portion of the supply step, the partial pressure of the precursor gas in the process chamber 201 is more easily increased. This reliably achieves the above-described effects.
(g) By supplying the dilution gas stored in advance in the second reservoir 260d into the process chamber 201 during at least a portion of step B, a large amount of dilution gas is more easily supplied into the process chamber 201. This makes it easier to precisely control the timing of start of supply of the dilution gas. Also, it is easier to further achieve effects such as shortening residence time of the precursor gas and decomposition products.
(h) When the supply step is performed under conditions that cause the precursor gas to thermally decompose in the process chamber 201, effects of an increase in the decomposition products on the step coverage becomes more pronounced as the precursor gas staying (residence) time increases. Even in such cases, the present disclosure is able to achieve the above-described effects.
(i) When a precursor gas containing two or more atoms of a predetermined element in its molecular structure is used, the effects of the increase in decomposition products on the step coverage becomes more pronounced as the precursor gas staying time increases. Even in such cases, the present disclosure is able to achieve the above-described effects.
(j) In the supply step, the first flow rate of the dilution gas is supplied into the process chamber 201 during at least a portion of step B, and no dilution gas is supplied into the process chamber 201 before the start of step B, thereby achieving the above-described effects.
(k) The first flow rate of dilution gas is supplied into the process chamber 201 during at least a portion of step B, and before the start of step B, either the dilution gas is not supplied into the process chamber 201 or a gas other than the process gas is supplied into the process chamber 201 at the second flow rate equal to or less than the first flow rate. Even in such cases, it is possible to achieve the above-described effects.
(l) By controlling the controller 121 to open the valve 247a and then the valve 247d, it is possible to start step B after step A0 is started and before step A2 ends. This achieves the above-described effects.
(m) By performing the exhaust step (i.e., the depressurization and purging of the process chamber 201) after step B, it is possible to increase or decrease the internal pressure of the process chamber 201. This makes it easier to discharge the precursor gas and decomposition products from the surface of the wafer 200 and the interior of the process chamber 201.
(n) In step B, the precursor gas and decomposition products are present on the surface of the wafer 200 and the interior of the process chamber 201 in greater amounts than during the exhaust step. Therefore, it is desirable that at least one selected from the group of the following conditions be met: purging in the exhaust step is performed for a shorter time than step B; and the fourth flow rate is lower than the dilution gas supply flow rate (first flow rate) in step B. This makes it easier to discharge the precursor gas and decomposition products in step B, while reducing an amount of inert gas consumed in purging in the exhaust step and time needed to process the wafer 200.

### (4) Modifications

The film formation sequence in the present embodiments may be changed as in the following modifications. These modifications may be used in proper combination. Unless otherwise stated, the processing procedures and process conditions in each step of each modification may be the same as the processing procedures and process conditions in each step of the above-described film formation sequence.

In this modification, step B may be started before the internal pressure of the process chamber 201 reaches the first local maximum value. A specific explanation is given below with reference to FIG. 5.

In FIG. 5, the vertical axis represents the internal pressure of the process chamber 201, and the horizontal axis represents time. A solid line shown in FIG. 5 indicates a change in the internal pressure of the process chamber 201 during the first processing step in the modification. A broken line shown in FIG. 5 indicates a change in the internal pressure of the process chamber 201 after time t3 when no dilution gas is supplied into the process chamber 201 within a predetermined time after the start of the flash supply of the precursor gas.

When no dilution gas is supplied in the first processing step, the internal pressure of the process chamber 201 into which the precursor gas is flash-supplied increases sharply between time t1 and time t4 and reaches a local maximum value v3 at time t4. The internal pressure of the process chamber 201, which reached the local maximum value v3, decreases between time t4 and time t6. A pressure v2 at time t2 is half of the local maximum value v3. When the dilution gas is supplied at time t3 after the flash supply of the precursor gas, the internal pressure of the process chamber 201 increases between time t3 and time t5 and reaches a local maximum value v4 at time t5. The internal pressure of the process chamber 201, which reached the local maximum value v4, decreases between time t5 and time t7, and the decrease in the internal pressure of the process chamber 201 ends at time t7. As shown in FIG. 5, the internal pressure of the process chamber 201 reaches a local maximum value for the first time at time t5.

Further, the step of increasing the internal pressure of the process chamber 201, for example, from time t1 to time t5, is referred to as first step A1. The step of decreasing the internal pressure of the process chamber 201, for example, from time t5 to time t7, is referred to as first step A2.

This modification also achieves at least some of the effects of the above-described embodiments.

In this modification, as shown in FIG. 5, it is desirable that step B is started during a period in which the internal pressure of the process chamber 201 is equal to or greater than half of the local maximum value v3 of the internal pressure of the process chamber 201 (e.g., a period from time t2 to time t4). This allows the precursor gas to sufficiently reach the deep side before the precursor gas and decomposition products are discharged outside the process chamber 201.

In this modification, as shown in FIG. 5, it is preferable that step B is started after step A1 is started for the first time. This allows the partial pressure of the precursor gas to be increased to a certain extent, allowing the precursor gas to sufficiently reach the deep side before the precursor gas and decomposition products are discharged outside the process chamber 201. This improves the step coverage of the film formed in the recess.

In the embodiments described above, the precursor gas is the main gas supplied into the process chamber 201 before the supply of the dilution gas is started. Therefore, before the supply of the dilution gas is started, the internal pressure (total pressure) of the process chamber 201 and the partial pressure of the precursor gas are considered to be substantially equal. From this, in this modification, the supply of the dilution gas is started before the partial pressure of the precursor gas in the process chamber 201 reaches its peak. In contrast, starting the supply of the dilution gas after the partial pressure of the precursor gas in the process chamber 201 reaches its peak facilitates the precursor gas to reach the deep side and then facilitates the precursor gas and decomposition products to be discharged outside the process chamber 201. This further improves the step coverage of the film formed in the recess.

### <Other Embodiments of the Present Disclosure>

The embodiments of the present disclosure are specifically described above. However, the present disclosure is not limited to the above-described embodiments, and various changes may be made without departing from the gist thereof.

In the above-described embodiments, an example is described in which the precursor gas and the dilution gas are flush-supplied in steps A0 and B, respectively. However, the present disclosure is not limited thereto. For example, in steps A0 and B, the precursor gas and the dilution gas may be supplied into the process chamber 201 without previously filling the first reservoir 260a and the second reservoir 260d, respectively (non-flash supply). In this case, the first reservoir 260a and one of the valves 243a and 247a may be omitted from the precursor gas supply system. Similarly, the second reservoir 260d and one of the valves 243d and 247d may be omitted from the dilution gas supply system. This embodiment also achieves at least some of the effects of the above-described embodiments.

In the above-described embodiments, an example is described in which the dilution gas is supplied into the process chamber 201 in step B. However, the present disclosure is not limited thereto. For example, the flow rate of the dilution gas supplied into the process chamber 201 may be increased in step B. In this embodiment, this allows the molar fraction of decomposition products (or the partial pressure of decomposition products) in the process chamber 201 to be reduced while preventing the precursor gas from staying (remaining) in the process chamber 201 for a long period of time, thereby achieving the same effects as the above-described embodiments.

In the above-described embodiments, an example of performing a film formation process in which a film containing a predetermined element is formed on the wafer 200, that is, a case in which the process gas is a gas that forms the film on the wafer 200, is described. However, the present disclosure is not limited thereto. For example, the process gas may be a gas other than the gas that forms the film on the wafer 200.

In the above-described embodiments, Si is used as an example of the predetermined element. However, the present disclosure is not limited thereto. For example, the predetermined element may be a metal element such as titanium (Ti), zirconium (Zr), hafnium (Hf), tantalum (Ta), niobium (Nb), aluminum (Al), molybdenum (Mo), tungsten (W), germanium (Ge), or the like, or may be nitrogen (N) or oxygen (O).

In the above-described embodiments, an oxidizing gas is used as an example of the reaction gas. However, the present disclosure is not limited thereto. For example, the reaction gas may be a reducing gas including a hydrogen (H₂) gas, a deuterium (D₂) gas, a borane (BH₃) gas, a diborane (B₂H₆) gas, a carbon monoxide (CO) gas, an ammonia (NH₃) gas, a monosilane (SiH₄) gas, a disilane (Si₂H₆) gas, a trisilane (Si₃H₈) gas, a monogermane (GeH₄) gas, a digermane (Ge₂H₆), or the like, or a nitriding gas including an ammonia (NH₃) gas, a diazene (N₂H₂) gas, a hydrazine (N₂H₄) gas, a N₃H₈ gas, or the like.

In the above-described embodiments, an example is described in which the first reservoir 260a and the valves 243a and 247a provided on the upstream and downstream sides of the first reservoir 260a, respectively, are provided on an upstream side of a junction of the gas supply pipes 232a and 232c. However, the present disclosure is not limited thereto. For example, the first reservoir 260a and the valves 243a and 247a may also be provided on a downstream side of the junction of the gas supply pipes 232a and 232c. The same applies to the second reservoir 260d and the valves 243d and 247d provided on the upstream and downstream sides of the second reservoir 260d, respectively.

In the above-described embodiments, an example is described in which an inert gas (i.e., a gas that is not reactive within the process chamber 201) is used as the dilution gas. However, the present disclosure is not limited thereto. The dilution gas may be any gas that reduces a concentration of the process gas in the process chamber 201 when supplied into the process chamber 201 simultaneously with the process gas, i.e., any gas that is not a process gas. The dilution gas may also be a gas that exhibits a chemical action, such as a gas that oxidizes or reduces the surface of the wafer 200 or members or gases within the process chamber 201. In this case, since there is a period during the first processing step in which the process gas and dilution gas are simultaneously present within the process chamber 201, it is desirable to use a gas, which does not react with the process gas in the gas phase, as the dilution gas. Also, inert gases are often less expensive than chemically active gases, and therefore using an inert gas as the dilution gas may reduce processing costs.

In the above-described embodiments, an example is described in which the dilution gas is flash-supplied into the process chamber 201. However, the present disclosure is not limited thereto. For example, the dilution gas may further include an inert gas supplied from the inert gas supply system. In this case, the dilution gas supply system may further include the gas supply pipes 232c and 232e, the MFCs 241c and 241e, and the valves 243c and 243e. When the dilution gas is supplied from a plurality of paths in this manner, a total flow rate of the dilution gas supplied from each path may be used as the flow rate of the dilution gas supplied in step B. Further, in purging the interior of the process chamber 201, the dilution gas may be further supplied into the process chamber 201, and the dilution gas may also act as a purge gas.

Recipes used in each process may be prepared individually according to the processing contents and may be recorded and stored in the memory 121c via a telecommunication line or the external memory 123. Moreover, it is desirable that, at the beginning of each process, the CPU 121a properly select an appropriate recipe from the recipes recorded and stored in the memory 121c according to the processing contents. Thus, it is possible for the processing apparatus to perform various processes for films of various film types, composition ratios, film qualities, and film thicknesses with enhanced reproducibility. Further, it is possible to reduce an operator's burden and to quickly start each process while avoiding an operation error.

The recipes mentioned above are not limited to newly-prepared ones but may be prepared, for example, by modifying existing recipes that are already installed in the processing apparatus. When modifying the recipes, the modified recipes may be installed in the processing apparatus via a telecommunication line or a recording medium recording the recipes. In addition, the existing recipes already installed in the existing processing apparatus may be directly modified by operating the input/output device 122 of the processing apparatus.

In the above-described embodiments, an example is described in which a film is formed by using a batch-type substrate processing apparatus capable of processing a plurality of substrates at a time. The present disclosure is not limited to the above-described embodiments, but may be suitably applied, for example, to a case where a film is formed by using a single-wafer type processing apparatus capable of processing a single substrate or several substrates at a time. In addition, in the above-described embodiments, an example is described in which a film is formed by using a substrate processing apparatus provided with a hot-wall-type process furnace. The present disclosure is not limited to the above-described embodiments, but may be suitably applied to a case where a film is formed by using a substrate processing apparatus provided with a cold-wall-type process furnace.

Even in the case of using these processing apparatuses, each process may be performed according to the same processing procedures and process conditions as those in the above-described embodiments and modifications, and the same effects as the above-described embodiments and modifications may be obtained.

The above-described embodiments and modifications may be used in proper combination. The processing procedures and process conditions used in this case may be the same as, for example, the processing procedures and process conditions in the above-described embodiments and modifications.

According to the present disclosure in some embodiments, it is possible to process an entire substrate uniformly.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
a supply process including:
(a0) supplying a process gas into a process chamber (201) in which the substrate (200) including a recess on a surface of the substrate (200) is placed;
(a1) increasing an internal pressure of the process chamber (201) at least partially simultaneously with (a0);
(a2) decreasing the internal pressure of the process chamber (201); and
(b) supplying a dilution gas into the process chamber (201) or increasing a flow rate of the dilution gas supplied into the process chamber (201),
the supply process being performed so that the internal pressure of the process chamber (201) reaches one or more local maximum values; and
an exhaust process of exhausting an interior of the process chamber (201) during at least a portion of the supply process,
wherein, in the supply process, (b) is started before (a2) ends for a first time.

2. The method of Claim 1, wherein, in the supply process, (b) is started after the internal pressure of the process chamber (201) reaches a first local maximum value among the one or more local maximum values.

3. The method of Claim 1, wherein (b) is performed such that the internal pressure of the process chamber (201) reaches a local maximum value among the one or more local maximum values after (b) is started.

4. The method of Claim 1, wherein, in the supply process, (b) is started before the internal pressure of the process chamber (201) reaches a first local maximum value among the one or more local maximum values.

5. The method of any one of Claims 1 to 4, wherein (b) is started during a period in which the internal pressure of the process chamber (201) is equal to or greater than half of a first local maximum value among the one or more local maximum values of the internal pressure of the process chamber (201) during the supply process.

6. The method of any one of Claims 1 to 5, wherein (b) is started after (a1) is started for a first time.

7. The method of any one of Claims 1 to 6, wherein the process gas stored in advance in a first reservoir (260a) is supplied into the process chamber (201) during at least a portion of the supply process.

8. The method of any one of Claims 1 to 7, wherein the dilution gas stored in advance in a second reservoir (260d) is supplied into the process chamber (201) during at least a portion of (b).

9. The method of any one of Claims 1 to 8, wherein the supply process is performed under a condition in which the process gas is thermally decomposed in the process chamber (201).

10. The method of any one of Claims 1 to 9, wherein, during at least a portion of (b), the dilution gas is supplied into the process chamber (201) at a first flow rate, and
wherein, before (b) is started, either the dilution gas is not supplied into the process chamber (201) or a purge gas is supplied into the process chamber (201) at a second flow rate equal to or less than the first flow rate.

11. The method of any one of Claims 1 to 10, wherein, in the supply process, the dilution gas is supplied into the process chamber (201) at a first flow rate during at least in a portion of (b),
the method further comprising:
performing a cycle once or more after an end of (b), the cycle including:
(c1) depressurizing the interior of the process chamber (201) without supplying a purge gas into the process chamber (201) or while supplying a purge gas into the process chamber (201) at a third flow rate equal to or less than the first flow rate; and
(c2) exhausting the interior of the process chamber (201) while supplying the purge gas into the process chamber (201) at a fourth flow rate equal to or greater than the third flow rate.

12. The method of Claim 11, wherein at least one selected from the group of following conditions is met: (c1) is performed for a shorter time than (b); and the fourth flow rate is lower than the first flow rate.

13. A method of manufacturing a semiconductor device, comprising the method of Claim 1.

14. A substrate processing apparatus comprising:
a process chamber (201) in which a substrate (200) including a recess on a surface of the substrate (200) is placed;
a supply system configured to supply a process gas and a dilution gas into the process chamber (201);
an exhaust system connecting the process chamber (201) to an exhauster and configured to control exhaust from an interior of the process chamber (201); and
a controller configured to control the supply system and the exhaust system so as to perform:
a supply process including: (a0) supplying the process gas into the process chamber (201); (a1) increasing an internal pressure of the process chamber (201) at least partially simultaneously with (a0); (a2) decreasing the internal pressure of the process chamber (201); and (b) supplying the dilution gas into the process chamber (201) or increasing a flow rate of the dilution gas supplied into the process chamber (201), the supply process being performed so that the internal pressure of the process chamber (201) reaches one or more local maximum values; and an exhaust process of exhausting the interior of the process chamber (201) during at least a portion of the supply process, wherein, in the supply process, (b) is started before (a2) ends for a first time.

15. A program that causes, by a computer, a substrate processing apparatus to perform a process comprising:
a supply process including:
(a0) supplying a process gas into a process chamber (201) in which a substrate (200) including a recess on a surface of the substrate (200) is placed;
(al) increasing an internal pressure of the process chamber (201) at least partially simultaneously with (a0);
(a2) decreasing the internal pressure of the process chamber (201); and
(b) supplying a dilution gas into the process chamber (201) or increasing a flow rate of the dilution gas supplied into the process chamber (201),
the supply process being performed so that the internal pressure of the process chamber (201) reaches one or more local maximum values; and
an exhaust process of exhausting an interior of the process chamber (201) during at least a portion of the supply process,
wherein, in the supply process, (b) is started before (a2) ends for a first time.
